# EUROPEAN PATENT SPECIFICATION

(11) **EP 1 593 204 B1**
(45) Date of publication and mention of the grant of the patent: **13.08.2008**
(21) Application number: 04711329.5
(22) Date of filing: 16.02.2004
(51) Int. Cl.: H03M 7/30, G06F 17/21, G06F 17/30

(54) **SYSTEM AND METHOD FOR COMPRESSION STRUCTURED DEFINITION LANGUAGE**
SYSTEM UND VERFAHREN ZUM KOMPRIMIEREN VON STRUKTURIERTER DEFINITION-SPRACHE
SYSTEME ET PROCEDE DE COMPRESSION DE LANGAGES A DEFINITION STRUCTUREE

(30) Priority: 14.02.2003 US 447430 P
(43) Date of publication of application: 09.11.2005
(73) Proprietor: Research In Motion Limited, Waterloo, Ontario N2L 3W8 (CA)
(72) Inventor: SHENFIELD, Michael, Richmond Hill, Ontario L4C 3S9 (CA)
(74) Representative: Rickard, David John
(86) International application number: PCT/CA2004/000209
(87) International publication number: WO 2004/073170

(56) References cited:
- EP-A- 0 896 284
- GIRARDOT M ET AL: "MILLAU: AN ENCODING FORMAT FOR EFFICIENT REPRESENTATION AND EXCHANGE OF XML OVER THE WEB" COMPUTER NETWORKS AND ISDN SYSTEMS, NORTH HOLLAND PUBLISHING. AMSTERDAM, NL, vol. 33, no. 1-6, June 2000 (2000-06), pages 747-765, XP001005949 ISSN: 0169-7552

## Description

### BACKGROUND

The present application relates generally to wireless network communications and wireless communication devices and in particular to compressing wireless applications for transfer to and from such devices.

As wireless communication devices and the wireless communication networks in which they are configured to operate continue to evolve, device users expect a wider range of functions from their devices. These communication devices can be such as but not limited to, wireless devices, PDAs, and the like. Modem wireless devices often enable such functions as web browsing, information downloading, and the like, that have typically been supported on larger and more powerful personal computers (PCs). However, PCs generally have larger and faster processors than wireless devices, and access to communication resources and power supplies that are less limited than those available on the wireless device.

Supporting these types of functions and applications on wireless devices is not just a matter of porting a software application or operating system to the wireless devices. The underlying protocols, transfer mechanisms, and data formats upon which these functions are based are not optimized for wireless communications. For example, extensible Markup Language (XML) is quickly becoming one of the most common schemes for exchanging data between different computer systems, but is characterized by a relatively large document size and thus is not suitable for transfer over wireless or other narrowband communication systems. Transfer of large amounts of data consumes limited device resources, in wireless devices, including both communication resources and power resources. Although compression or encoding schemes targeted to wireless devices, such as Wireless Application Protocol (WAP) Binary XML (WBXML), are known, these encoding schemes generally provide limited benefit and must pass dictionaries containing the encoding scheme between the device and the application source. A further disadvantage with the WBXML encoding scheme is that it is required to pass a binary dictionary with the encoded application definition during transfer of the encoded application from an application provider to the recipient communication device.

Prior art systems such as that discussed by M.Girardot et al in "Millau: an encoding format for efficient representation and exchange of XML over the Web"(June) which discloses a method for compressing XML structures and data for exchange over, 2000) the internet. Girardot's method includes the transmission of two separate data streams, one containing the structure, the other containing the content of the document. The Girardot system seeks to improve encoding schemes that do not retain structural information in the exchanged data and is primarily concerned with the reduction of transmission size of XML documents (page 749, left column). The document also describes the tokenization of primitive types for further compressing the attribute values.

Systems and methods of application compression are provided for application transfer in wireless network communications to obviate or mitigate at least some of the above presented disadvantages.

Extensible Markup Language (XML) is quickly becoming one of the most common schemes for exchanging data between different computer systems, but is characterized by a relatively large document size and thus is not suitable for transfer over wireless or other narrowband communication systems. Transfer of large amounts of data consumes limited device resources, in wireless devices, including both communication resources and power resources. Although compression or encoding schemes targeted to wireless devices, such as Wireless Application Protocol (WAP) Binary XML (WBXML), are known, these encoding schemes generally provide limited benefit. A further disadvantage with the WBXML encoding scheme is that it is required to pass a binary dictionary with the encoded definitions during transfer of the encoded application from an application provider to the recipient communication device.

Contrary to present encoding schemes, systems and methods of compressing non-displayable elements of software applications are provided. A received software application includes common tags and attributes for a class of software applications, application-specific elements, and displayable data. The common tags and attributes are encoded, and the application-specific elements are also encoded, while the displayable data remains unencoded. A compressed software application, including the encoded common tags and attributes, the encoded application-specific data, and the unencoded displayable data, is thereby generated. The information source of the encoded application and the recipient destination device may share knowledge of the compression codes used for encoding the predefined common and predefined application specific elements.

Accordingly, in a first aspect, there is provided a method according to claim 1, of compressing a wireless software application expressed in a structured definition language, the application having a plurality of elements predefined according to an application definition template and a plurality of display elements configured for presentation on a user interface of a recipient wireless device, the method comprising the steps of: selecting a compression format according to a compression dictionary containing a plurality of codes for representing the predefined elements of the application as encoded elements; encoding common elements of the predefined elements using the selected compression format, the common elements representing the common structure for a class of software applications; characterized by the steps of: making a distinction between the display elements and non-display elements of the application; encoding application specific elements of the predefined elements using the selected compression format, the encoded application specific elements comprising only non display elements, the display elements being retained in uncompressed form; and combining the uncompressed display elements, the encoded common elements and the encoded application specific elements for generating a compressed version of the application; wherein the compression dictionary is configured for use by the recipient wireless device of the compressed application using knowledge of the application definition template contents.

Accordingly, in a second aspect, there is provided a method according to claim 9, of decompressing a compressed wireless software application expressed in a structured definition language, the application having a plurality of encoded elements predefined according to an application definition template and a plurality of uncompressed display elements configured for presentation on a user interface of a recipient wireless device, knowledge of the application definition template contents being shared between the device and an application provider of the compressed application, the method comprising the steps of: selecting a decompression format according to a compression dictionary containing a plurality of codes for representing the predefined elements of the application as encoded elements; decoding selected ones of the predefined elements using the selected compression format, the predefined elements comprising common elements representing a common structure for a class of software applications; characterized by the steps of: decoding application specific elements only when representing non-display elements of the application, the display elements of the application content being retained in uncompressed form; and combining the decoded predefined elements and the display elements in an uncompressed version of the application configurable for subsequent execution on a runtime environment of the device.

Also provided as a third aspect is a system according to claim 24, for compressing a wireless software application expressed in a structured definition language, the application having a plurality of elements predefined according to an application definition template and a plurality of display elements configured for presentation on a user interface of a recipient wireless device, the system comprising: an application definition template for defining the predefined elements and comprising information on the display elements; a compression dictionary representing a compression format containing a plurality of codes for representing the predefined elements of the application as encoded elements; an encoder for encoding the predefined elements and common elements using the compression format, the common elements representing a common structure for a class of software applications; characterized in that there is a distinction between the display elements and non-display elements of the application and that the encoder is configured to encode only non-display elements of the predefined elements and the common elements , the display elements of the application content being retainable by the encoder in uncompressed form; and a generator for combining the uncompressed display elements, the encoded common elements and the encoded application specific elements for generating a compressed version of the application; wherein the compression dictionary is configured for use by the recipient wireless device of the compressed application using shared knowledge of the application definition template contents.

Further, provided as a fourth aspect is a system for decompressing, according to claim 39, compressed wireless software application expressed in a structured definition language, the application having a plurality of encoded elements and a plurality of uncompressed display elements configured for presentation on a user interface of a recipient wireless device, the system comprising: an application definition template for defining predefined elements and comprising information on the display elements, knowledge of the application definition template contents being shared between the device and an application provider of the compressed application; a compression dictionary representing a compression format containing a plurality of codes for representing the predefined elements of the application as encoded elements; a decoder for decoding the predefined elements including common elements and application specific elements using the selected decompression format, the common elements representing a common structure for a class of software applications; characterized by: the decoder being configured to decode only non-display elements of the predefined elements the display elements of the application content being retained in uncompressed form; and a generator for combining the uncompressed display elements and the decoded predefined elements in an uncompressed version of the application configurable for subsequent execution on a runtime environment of the device.

There is also provided as a fifth aspect a computer program product according to claim 40, for compressing or decompressing a wireless software application expressed in a structured definition language, the application having a plurality of predefined elements and a plurality of display elements configured for presentation on a user interface of a recipient wireless device, the computer program product comprising: a computer readable medium comprising program code means executable by a processor of a computing device, apparatus or system for implementing the method of the first aspect or the method of the second aspect.

### BRIEF DESCRIPTION OF THE DRAWINGS

A better understanding can be obtained with reference to the following drawings and detailed description herein below, in which:
Fig. 1 is a block diagram of a communication system that provides access to an information source from communication devices;
Fig. 2 is a block diagram of the device of Fig. 1;
Fig. 3a is a flow diagram illustrating a method of compressing software applications of the system of Fig. 1;
Fig. 3b is a flow diagram illustrating a method of decompressing software applications of the system of Fig. 1;
Fig. 4 is a block diagram of a system for handling compressed software applications of the system of Fig. 1;
Fig. 5 is a block diagram of a software application compression tool of the system of Fig. 1;
Fig. 6 is a further example of the system of Fig. 1 as a first compressed software application system topology; and
Fig. 7 is a further example of the system of Fig. 1 as a second compressed software application system topology.

### DETAILED DESCRIPTION

### Network System

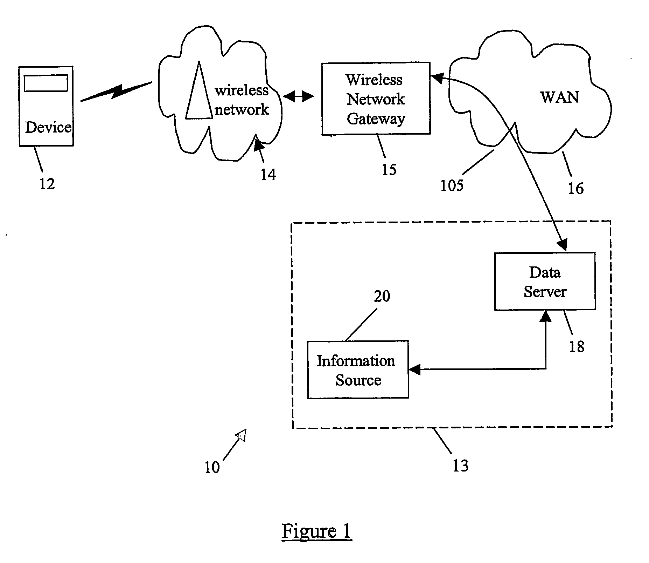

Referring to Figure 1, a network system 10 comprises a plurality of devices 12 for interacting with one or more generic information services 13, provided by a data server 18 and associated information source 20, through request/response messages 105 a suitable communication channel, or combinations of channels, such as modem, serial connection or computer network including, without limitation, a coupled Wide Area Network (WAN) 16 such as but not limited to the Internet. The data server 18 effectively provides the devices 12 with access to the information source 20 of the information service 13. The functionality of information service 13 can be integrated within a single computer system or be distributed across multiple computer systems adapted with appropriate communication interfaces. The devices 12 can be such as but not limited to PDAs, cellular phones, and the like. The generic information service 13 can be Web Services and/or other services such as but not limited to SQL Databases, IDL-based CORBA and RMI/IIOP systems, and COM/DCOM components. Further, the system 10 also has a wireless network 14 for connecting the wireless devices 12 to the WAN 16.

The wireless devices 12 are wireless communication devices adapted to operate within the wireless communication network 14, such as a two-way communication device having at least data and possibly voice communication capabilities, for example. A wireless network gateway 15 provides an interface between the wireless network 14 and the WAN 16, and performs such functions as wireless device addressing, and storing and forwarding data to and from the wireless devices 12. The wireless network gateway 15 shown in Figure 1 provides an interface between the wireless network 14 and a WAN 16 such as the Internet, for example. Such functions as wireless device addressing, storing and forwarding data to and from the wireless device 12, and other interface functions can be performed by the wireless network gateway 15. Depending on the functionality provided by the wireless device 12, it may operate such as but not limited to a data messaging device, a two-way pager, a mobile telephone with data messaging capabilities, a wireless Internet appliance, a data communication device (with or without telephony capabilities), and/or a wireless modem configured to operate in conjunction with a computer system or other electronic device, however herein is referred to the wireless device 12. It is recognized that other devices and computers (not shown) could be connected to the data server 18 via the WAN 16 and associated networks other than as shown in Figure 1.

Web services 13 are selected by example to represent the information services 13 in the following description of the system 10, for the sake of simplicity. However, it is recognized that other generic information services 13 could be substituted for the web services 13, if desired. Further, the networks 14, 16, and any appropriate gateway servers as needed to allow intercommunication among such networks, of the system 10 will hereafter be referred to collectively as "the network 16" for the sake of simplicity.

The particular design of a communication subsystem within the wireless device 12 is dependent upon the communication network 14 in which the wireless device 12 is intended to operate. For example, a wireless device 12 destined for a North American market may include a communication subsystem designed to operate within the MobitexTM mobile communication system or DataTACTM mobile communication system, whereas a wireless device 12 intended for use in Europe may incorporate a General Packet Radio Service (GPRS) communication subsystem. Other types of wireless devices and networks are also contemplated. The systems and methods described herein may be implemented in conjunction with virtually any wireless network 14 and wireless device 12.

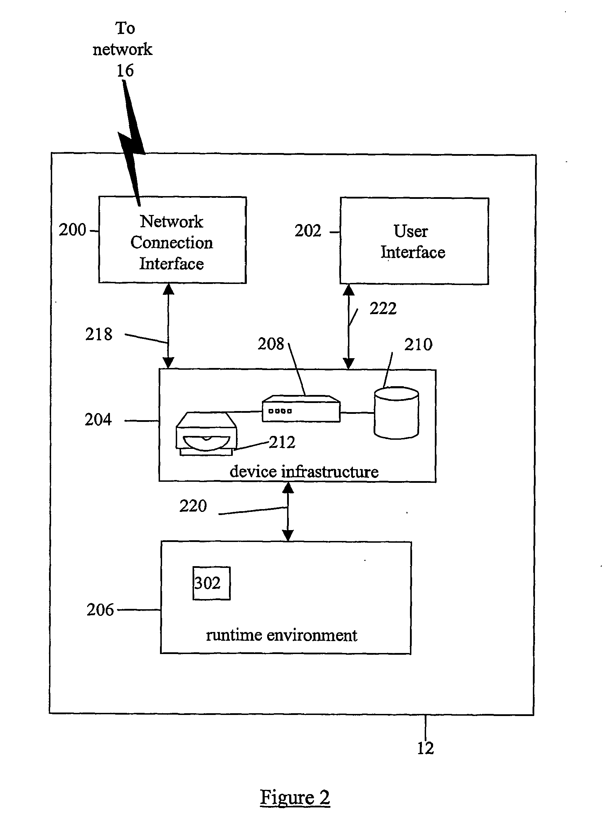

Referring again to Figure 1, the devices 12 transmit and receive the request/response messages 105, respectively, when in communication with the data server 18 of the web services 13. The devices 12 can operate as web clients of the web services 13 by using the request/response messages 105 in the form of message header information and associated data content, for example requesting and receiving product pricing and availability from an on-line merchant. The web service 13 is an example of a system with which client application programs 302 (see Figure 2) on the devices 12 interact via the network 16 in order to provide utility to users of the devices 12. The network system 10 employs a compression scheme for reducing the size of the applications 302, as further described below, which can be used for device 12 footprint and/or network 16 bandwidth considerations. It is recognised that the messages 105 are used to transfer the applications 302 and/or associated messages (including displayable data) during operation (for example) of the applications 302 on the device 12 , during interaction with the web service 13.

For satisfying the appropriate request/response messages 105 of the web service 13, the data server 18 can communicate with the information source 20 through various protocols (such as but not limited to HTTP and component API) for exposing relevant business logic (methods) to client application programs 302 (see Figure 2) of the devices 12. Through the data server 18, the devices 12 may access any information source 20 that can communicate with the data server 18. The data server 18 can also contain the web service 13 interface software, such as but not limited to specification using one or more structured definition and/or scripting languages such as Web Services Description Language (WSDL) and Business Process Execution Language (BPEL). The information source 20 may be a local data store at the data server 18, or a remote store associated with a web server (not shown), for example. Further, the data server 18 and the information source 20 may comprise a distributed web service 13 and communicate through the network 16, including the Internet, rather than the direct connection as shown in Figure 1. The information source 20 can be considered a source from which data is available to the device 12. This data may be either requested by the device 12 or sent to the device 12 by the information source 20 without first being requested. It will be appreciated that the information source 20 could incorporate the data server 18 or some other means to facilitate data exchange for the web service 13, if desired.

The application programs 302 (see Figure 2) of the device 12 can use the business logic of the information source 20 similarly to calling a method on an object (or a function). It is recognized that the client application program 302 can be downloaded/uploaded in relation to the information source 20, through the messages 105 via the network 16, directly to the devices 12. It is further recognized that the devices 12 can communicate with one or more web services 13 via the network 16. It is also recognized that the devices 12 could be directly coupled to the information source 20, thereby bypassing the data servers 18, if desired. In alternative configurations, functions of the data server 18 can be incorporated into the gateway 15 or the information source 20, as described below. An application service provider, for example, may combine the data server 18 and the information source 20.

Although the wireless device 12, the wireless network 14, and the wireless network gateway 15 are shown in Fig. 1, the disclosed systems and methods may also be applicable to various types of wireless network topologies, wireless communication systems, and wireless devices. For example, processing resources and communication link bandwidth tend not to be as limited for desktop computer systems and wired communication links as for wireless devices and wireless communication networks, but compressing the size of data may in some implementations also provide for faster transfer of documents via wired connections.

### Server Environment

In general, web services 13 have come as a replacement for legacy Browser-based and Client-Server TCP/IP connected infrastructure and applications. Originally started as a generic machine-to-machine (M2M) communication protocol, web services 13 are becoming a standard for any service-to-service (S2S) or service to consumer (S2C) communications. Based on a set of standard protocols (e.g. WSDL, Simple Object Access Protocol (SOAP), Universal Description, Discovery, and Integration (UDDI)), web services 13 can provide a platform neutral communication pipe, for example XML-based, that can support synchronous and/or asynchronous communication messages 105. The system 10 of Figure 1 relates preferably to the S2C model and deals with the consumer of the web service 13 operating from some generic terminal device 12.

Referring to Figure 1, the web service 13 provides the information messages 105 which are used by the client application programs 302 (see Figure 2) of the devices 12. Alternatively, or in addition, the web service 13 may receive and use the information messages 105 provided by the devices 12, or perform tasks on behalf of client application programs 302 executed on the devices 11. The web service 13 can be considered a software service of the data server 18, which can implement an interface expressed using WSDL registered in UDDI, and can communicate through messages 105 with client devices 12 by being exposed over the network 104 through SOAP. SOAP is a specification that defines an XML format for the messages 105, including a well-formed XML fragment enclosed in SOAP elements. Alternatively, the web service 13 may use other known communication protocols, message 105 formats, and the interface may be expressed in other web services languages than described above for communication with the devices 12.

### Communication Device

Referring to again to Figures 1 and 2, the devices 12 are devices such as but not limited to mobile telephones, PDAs, two-way pagers or dual-mode communication devices. The devices 12 include a network connection interface 200, such as a wireless transceiver, serial/parallel port or a modem, coupled via connection 218 to a device infrastructure 204. The connection interface 200 is connectable during operation of the devices 12 to the network 16, such as to the wireless network 14 by, for example, RF links, which enables the devices 12 to communicate with each other and with external systems (such as the web service 13) via the network 16 and to coordinate the request/response messages 105 between the client application programs 302 and the web service 13. The network 16 supports the transmission of data in the request/response messages 105 between devices 12 and external systems, which are connected to the network 16. The network 16 may also support voice communication for telephone calls between the devices 12 and devices which are external to the network 16. The particular design of the network connection interface 200 within the wireless devices 12 will be dependent upon the wireless communication network 14 in which the wireless device 12 is intended to operate. For example, the wireless device 12 destined for a North American market may include the network connection interface 200 designed to operate within the Mobitex TM mobile communication system or DataTAC TM mobile communication system, whereas the wireless device 12 intended for use in Europe may incorporate a General Packet Radio Service (GPRS) the network connection interface 200. Other types of wireless devices and data transmission protocols are also contemplated, such as but not limited to Code Division Multiple Access (CDMA).

Referring again to Figure 2, the devices 12 also have a user interface 202, coupled to the device infrastructure 204 by connection 222, to interact with a user (not shown). The user interface 202 includes one or more user input devices such as but not limited to a QWERTY keyboard, a keypad, a trackwheel, a stylus, a mouse, a microphone and the user output device such as an LCD screen display and/or a speaker. If the screen is touch sensitive, then the display can also be used as the user input device as controlled by the device infrastructure 204. The user interface 202 is employed by the user of the device 12 to coordinate the requests/response message messages 105 over the system 10 (see Figure 1) as employed by client application programs 302 of a client runtime environment 206, further described below.

Referring again to Figure 2, operation of the device 12 is enabled by the device infrastructure 204. The device infrastructure 204 includes a computer processor 208 and an associated memory module 210; the computer processor 208 can include one or more processing elements that may include one or more general purpose processors and/or special purpose processors (e.g., ASICs, FPGAs, DSPs, etc.). The computer processor 208 manipulates the operation of the network interface 200, the user interface 202 and the client runtime environment 206 of the device 12 by executing related instructions, which are provided by an operating system and client application programs 302 located in the memory module 210.

Further, it is recognized that the device infrastructure 204 can include a computer readable storage medium 212 coupled to the processor 208 for providing instructions to the processor 208 and/or to load/update client application programs 302 in the memory module 210. The computer readable medium 212 can include hardware and/or software such as, by way of example only, magnetic disks, magnetic tape, optically readable medium such as CD/DVD ROMS, and memory cards. In each case, the computer readable medium 212 may take the form of a small disk, floppy diskette, cassette, hard disk drive, solid state memory card, or RAM provided in the memory module 210. It should be noted that the above listed example computer readable mediums 212 can be used either alone or in combination. It is also recognized that the instructions to the processor 208 and/or to load/update client application programs 302 in the memory module 210 can be provided over the network 16 (see Figure 1) by the web service 13 (or third party source) to configure the device 12 for interaction with the web services 13.

Referring to Figure 2, the device 12 executes the application programs 302 by the client runtime environment 206, which can convert the applications 302 into native code, which is executed by a processor 208 in the device infrastructure 204; multiple such runtime environments could potentially be available for use by the processing framework 206 of a given device 12. Alternatively, the applications 302 may be executed as native code or interpreted by another software module or operating system on the device 12. In any event, the component applications 302 are run in the terminal runtime environment provided by the device 12.

Referring again to Figure 1, the client runtime environment provided by the devices 12 can be configured to make the devices 12 operate as web clients of the web services 13. The client runtime environment of the devices 12 is preferably capable of generating, hosting and executing the client application programs 302 on the device 12; if multiple runtime environments are available, a particular one can be selected for use with a given application program 302. Further, specific functions of the client runtime environment can include such as but not limited to support for language, coordinating memory allocation, networking, management of data during I/O operations, coordinating graphics on an output device of the devices 12 and providing access to core object oriented classes and supporting files/libraries. Examples of the runtime environments implemented by the devices 12 can include such as but not limited to Common Language Runtime (CLR) by Microsoft and Java Runtime Environment (JRE) by Sun Microsystems, which facilitate generation, transmission, and reception of the network messages 105 between the web service 13 and the devices 12.

### Compression Scheme

In general, wireless application space is rapidly growing and with the variety of different deployment platforms and devices 12, XML (for example) is becoming the structured definition language of choice for use in software application definitions. Using XML, one can define software application screens, data structures, and messages exchanged through request/response messages 105 between the devices 12 and the data servers 18 or application service providers 13. The device-based execution environment 206 either generates native software code components from language (e.g. XML) definitions of the application 302 or directly operates on the structured definition language used to express the application 302. In other words, the runtime environment 206 either executes the XML code directly, or first translates the XML code into a corresponding native code representation prior to execution.

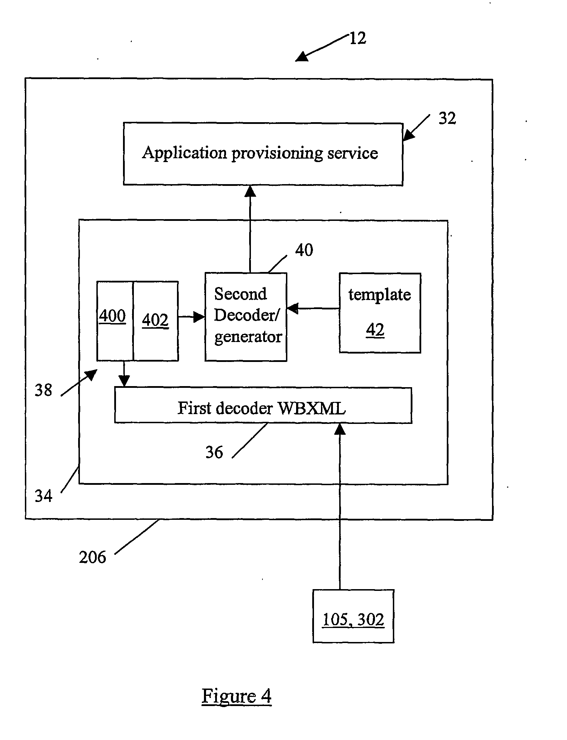

The XML approach allows software application developers to build software applications 302 targeted to different devices 12 with minimal portability issues. In order for the execution environment 206 (see Figure 2) to be able to interact with XML-defined applications, the format of associated XML definitions preferably complies with a predefined application definition template 42 (see Figure 4), such as but not limited to a Document Type Definition (DTD) or an XML schema. This creates a unique situation where both the device 12 and the content or service provider 13 share knowledge of the definition format included in the definition template 42. This shared knowledge of the software application 302 definition format provides an opportunity for greater compression of the XML software application 302 over that commonly used in known WBXML compression, by example. It is recognized that the below described compression scheme for XML based applications 302 can be applied to other structured definition languages having predefined definition formats, such as but not limited to other markup languages including variations of XML.

In accordance with a further possible feature in some implementations, improved compression results can be achieved by compression (e.g. binary obfuscation) of at least some non-displayed data, thereby making a distinction during compression of the content of the application 302 between non-displayed data and displayed data (to the end user of the application 302). In such cases, only predefined application elements may be encoded, such as XML tags and attributes that are common for a given class of software applications and application-specific values that are not displayed to the end user of the devices 12. Those parameters of the application 302 content that are displayed to the user of the' device 12 are not encoded by the compression scheme. The compression scheme can thereby reduce the size of an over-the-air (OTA) provisioned, XML-defined, software application 302, for example.

Thus, the compression scheme, as further described below, can exploit the fact that only displayable data/parameters (to application users on the user interface 202 of the device 12 - see Figure 2) are sent via messages 105 to the device 12 without compression. Common predefined elements such as internal names and attributes of the software application 302 can be binary encoded and sent to the device 12 in the compressed form. On the device 12, there can be no need to decode these encoded predefined names and attributes to the original unencoded names and attributes (as per developer definition), because these are only stored internally and not displayed to the user on the user interface 202 of the device 12 (see Figure 2). Upon arrival to the device 12, encoded application internal names and attributes of the compressed application 302 can in some implementations be either restored to generated character sequences (i.e. native code or other executable formats) or kept in the compressed binary format, depending on the execution environment 206 (see Figure 2) capabilities. It is recognised that the compression scheme could use conversion formats other than binary for representation of the compressed predefined elements of the application 302.

Referring to Figure 4, it is noted that the template 42 can be shared between the device 12 and the web service 13 (e.g. a content or service provider) of the application 302, and would therefore be available for decoding common application elements (e.g. XML element tags and attributes common to a plurality of applications 302) at provisioning time, in the event the runtime environment 206 required decoded elements for processing. Further, the template 42 contents can include the predefined application elements of the application program 302, as compared to the dynamically changing elements (displayable parameters) intended for display on the user interface 202 (see Figure 2). These display elements can be generated dynamically by both the web service 13 and the users of the device 12. Accordingly, there may be no need to repeatedly pass a compression dictionary 38 with the encoded software application 302 and related encoded response/request messages 105. It should be recognised that the encoded predefined application-specific and common data definitions do not typically contain any information displayable to the device user and can be kept in encoded form to further reduce the application 302 footprint when loaded or otherwise provisioned on the device 12. The dictionary 38, for example, could use a binary compression format, as desired.

Referring again to Figure 4 the runtime environment 206 of the device 12 is configured for handling compressed software applications 302 received (for example) via the messages 105. Those skilled in the art will appreciate that only the components directly involved in handling compressed software applications 302 are included in Fig. 4, and that the device 12 typically includes further components than those shown, such as in Figure 2. The device 12 enabled for compressed software applications 302 includes an application provisioning service 32 that supports software application 302 downloading, and can include an application decoder 34 for decompressing or restoring the received compressed XML application 302.

The compression dictionary 38 of the decoder 34 contains a common element dictionary 400 for decoding of common predefined elements (e.g. XML names and attributes) and an application specific element dictionary 402 for processing predefined application-specific elements (e.g. attribute values). A first common element decoder 36 (such as but not limited to an WBXMI, decoder) uses the dictionary 400 to decode the common XML elements and attributes which can define the application 302 resources. The application definition template 42 contains information about the common structure of the given class of applications 302, as defined for example such as but not limited to by a DTD or an XML schema, and can also contain knowledge about displayable parameters and other non-encodable data for coordinating the processing and display thereof. A second value decoder/name generator 40 uses the application specific dictionary 402 to restore, and validate in some implementations, for example, if required by the runtime 206, predefined application-specific elements. Optionally, the second decoder 40 further processes the resulting decoded application 302 definition to generate or restore character-based attribute values, where the device execution environment 206 is unable to store and execute these parameters in the compressed format.

Referring again to Figure 4, when the compressed application 302 definition is provisioned to the device 12, the first decoder 36 retrieves the dictionary 400 for the corresponding class of wireless software applications 302 from the compression dictionary 38 and decodes the common predefined XML elements and attributes accordingly. After decoding common predefined XML elements and attributes, the partially decoded application 302 definition is passed to the second decoder 40, which retrieves the application specific dictionary 402 to decode predefined application-specific attribute values. Application structure information of the application template 42 is retrieved to encourage proper handling and assignment of the decoded attribute values for both the common and application specific elements. The decoded application 302 definition is optionally further processed by the second decoder 40 to complete conversion of the decoded attributes, typically from binary to text. When ready, the decoded application 302 definition is passed to the application provisioning service 32, and, for example, installed for execution on the device 12. It is recognised that the above described decoder 34 components and operation are also applicable to decoding messages 105 (see Figure 1) received by the device 12 from the web service 13 during operation of the provisioned decoded application program 302. It is further recognised that the decoder 34 can be represented as having the two specialized decoders 34, 40, as described above, or can be represented as a combined decoder for decoding both common and application specific predefined elements. It is further recognised that the decoder 34 could be implemented on the data server 18 and/or the information source 20 of the web service 13 (see Figure 1), for decoding the compressed content of any messages 105 received from the device 12 when acting as a web client of the web service 13.

Further, it is recognised that the dictionary 38 can be separate from the decoder 34 and that the decoding process (when implemented by the runtime environment 206) can decode a portion or all of the predefined common and application specific elements, as desired. For example, the runtime environment 206 could use the dictionary to decode the application specific elements and leave the common elements in their compressed format on the device 12.

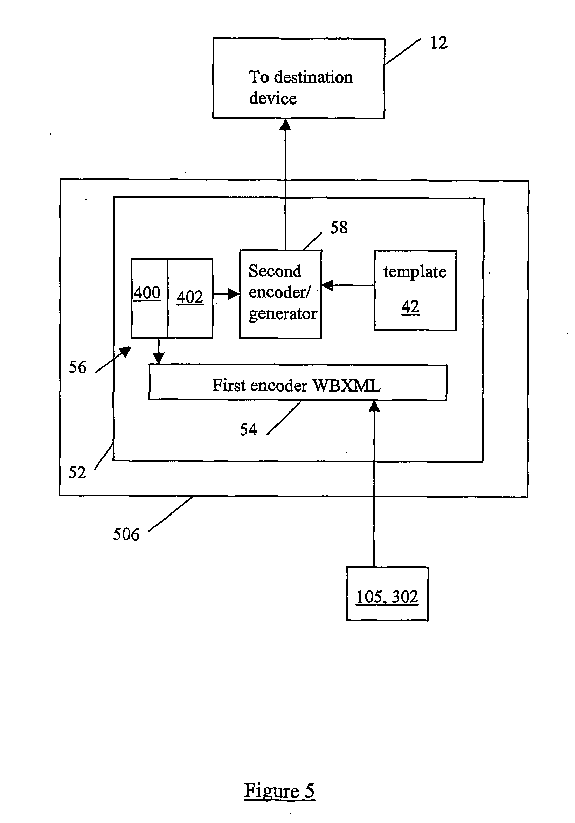

Referring to Fig. 5, a block diagram of a software application compression tool 52 is shown. As in Fig. 4, Fig. 5 includes those components directly involved in software application 302 compression. The compression tool 52, or a system (such as a runtime environment 506) in conjunction with which the compression tool 52 is configured to operate, may include further components in addition to those in Fig. 5. It is recognised that the runtime environment 506 could be part of the service provider 13 system (on the server 18 and/or the source 20) and could also be part of the runtime environment 206 of the device 12.

The compression tool 52 receives the software application 302 from the local or remote application source 20, compresses the software application 302, and provides the compressed software application 302 to a destination. The destination is either the device 12 or system configured to handle compressed software applications 302, or possibly the application source 20. For example, the compressed software application 302 is returned to the application source 20 when the application source 20 uses the remote compression tool 52 to compress its software applications 302, but then stores the compressed software applications 302 for subsequent transmission to properly configured devices 12 or systems.

Referring again to Figure 5, in the compression tool 52 the compression dictionary 38 contains the common dictionary 400 for encoding of common XML elements and attributes and the application specific dictionary 402 for processing application-specific attribute values. The dictionary 38 includes the same matching dictionaries 400, 402 as those stored in the dictionary 38 at the destination device 12 or system configured to handle software applications 302 that have been compressed by the compression tool 52. However, it should be appreciated that the dictionary 38 may also include further common and application specific dictionaries 400, 402 representing other templates 42 and applications 302 definitions for a variety of devices 12. A first encoder 54 (e.g. WBXML) uses the dictionary 400 to encode XML elements and attributes which define application resources. The application definition template 42 contains information about the common structure of the specific class of applications 302 (including both wired and wireless) and information about displayed parameters and any other non-encodable data. The second encoder (e.g. a binary obfuscator) 58 uses the application specific dictionary 402 from the dictionary 38 to encode, for example obfuscate and binary encode, application-specific attribute values.

The software application definition template 42 is received by the compression tool 52 and passed to the first encoder 54, which retrieves the common dictionary 400 for the appropriate class of software applications 302 from the binary dictionary 38. After encoding common XML elements and attributes, the first encoder 54 passes the partially encoded application 302 definition to the second encoder 58. The second encoder 58 retrieves the application specific dictionary 402 from the dictionary 38 to encode/obfuscate application-specific attribute values, and retrieves application structure information from the application definition template 42 to encourage the integrity of the encoded application 302 after obfuscation. When binary obfuscation is complete, the encoded and compressed application 302 definition is released to the destination, either the intended recipient device 12 or system or, for example, a software application 302 repository at the application source 20. It is recognised that the above described encoder 52 components and operation are also applicable to encoding messages 105 (see Figure 1) received/sent by the device 12 from/to the web service 13 during operation of the provisioned decoded application program 302. It is further recognised that the encoder 52 can be represented as having the two specialized encoders 54, 58, as described above, or can be represented as a combined encoder for encoding both common and application specific predefined elements. It is further recognised that the encoder 52 could be implemented on the data server 18 and/or the information source 20 of the web service 13 (see Figure 1), for encoding the compressed content of any messages 105 sent to the device 12 when acting as a web client of the web service 13. It is further recognised that the encoder 52 could be implemented on the device 12 for encoding the compressed content of any messages 105 sent to the data server 18 and/or the information source 20 of the web service 13 (see Figure 1).

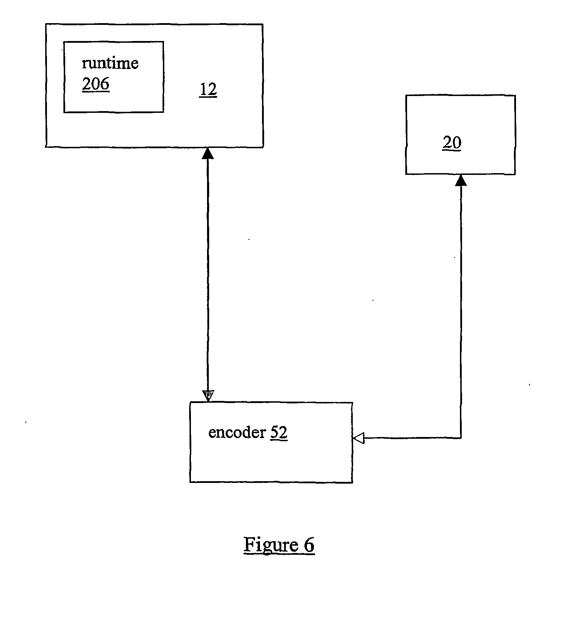

Compressed software application systems are applicable to a variety of potential topologies. Fig. 6 is a block diagram of a first compressed software application system topology. In the first topology, the compression tool 52 receives software applications 302 from the application source 20 and transmits compressed software applications 302 to the device 12, which can include the compressed application system runtime 206, such as shown in Fig. 4. The compression tool 52 is implemented in an intermediate system and compresses and distributes software applications 302 on behalf of the application source 20. In a variation of this topology, compressed software applications 302 are returned to the application source 20, which itself distributes the compressed software applications 302. A "hybrid" variation is also contemplated, wherein software applications 302 are remotely compressed, and distributed by both the compression tool 52 and the application source 20, depending upon the intended destination device 12 or system or the type of software application 302, for example.

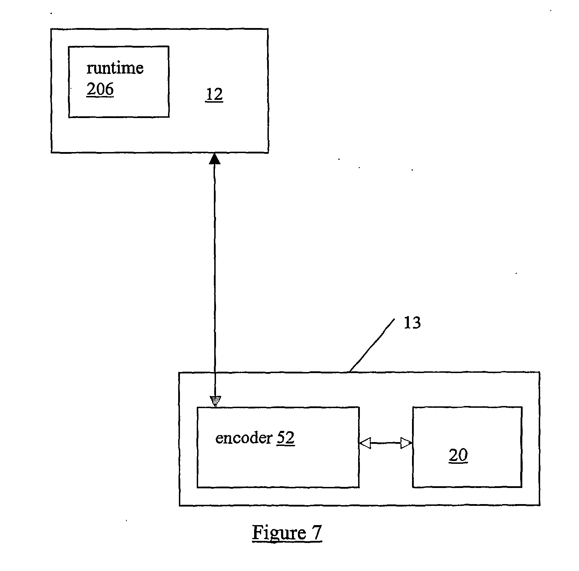

Fig. 7 is a block diagram of a further compressed software application system topology. In the second topology, the application service provider 13 includes both an application source 20 and a compression tool 52. The device 12 and the compressed application runtime 206 are substantially the same as the similarly labelled components in Fig. 6. As such, it is apparent from Figs. 4 and 5 that the device 12 implementation is independent of topology. Although each topology has been shown and described separately, the device 12 may be configured to communicate with application sources 20 or service providers 13 that support either topology. It is also contemplated that the device 12 may communicate with a plurality of information sources 20, of which some support the Fig. 6 topology, and others support the Fig. 7 topology. Similarly, the application source 20 might also support both topologies to expand the types of encoding that are available for compressing software applications 302.

An integrated system such as shown in Fig. 7 can be particularly advantageous when confidential or otherwise sensitive information is provided by the application source 20. In this case, no intermediate component is required to compress information. For example, confidential information that is encrypted at the service provider 13 remains encrypted until decrypted at the device 12 and vice-versa, providing end-to-end security.

### Example Operation of Binary Compression Scheme

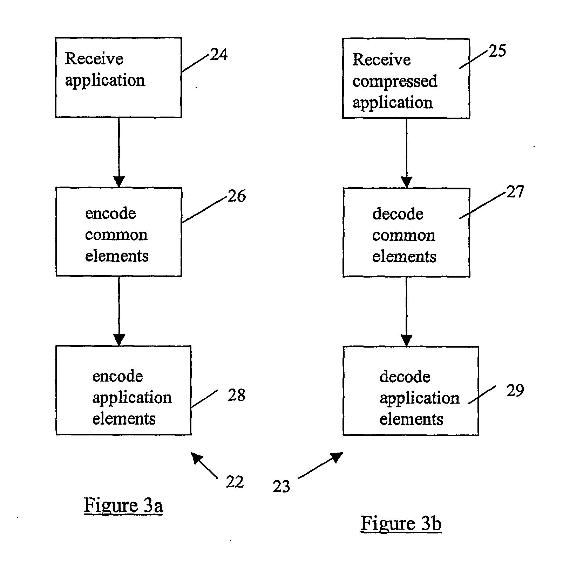

Fig. 3a is a flow diagram illustrating a method of compressing software applications 302. The method 22 includes two phases - binary conversion of common predefined tags and attributes and binary obfuscation for predefined application-specific data. Fig. 3b is a flow diagram illustrating a method of decompressing software applications 302. The method 23 includes two phases - binary decoding of common predefined tags and attributes and binary decoding of predefined application-specific data.

Referring to Figures 3a and 5, at step 24, the software application 302 is received by the compression tool 52, from the information source such as 20 (see Figure 1). As described below, the compression tool 52 may be implemented at the content or service provider 13 along with the information source 13, or at a separate system (not shown) that performs compression for the information source 20, such as an intermediate third party device 12 or system between the information source 20 and the destination device 12 intended to receive the compressed software application 302. Using the application definition template 42 such as the DTD or XML schema, for example, common predefined element names and attributes in the application template 42 are binary encoded at step 26. This encoding of common predefined elements is such that the binary codes for the predefined element names and attributes, in the binary compression dictionary 38, is shared between the compression tool 52 and destination device 12. As such, unlike WBXML encoding, it is not required to pass the binary compression dictionary 38 with the encoded application 302 definition.

Using a hierarchical structure of the application 302 definition, step 28 involves binary encoding of the predefined application-specific data not displayed to the user of the device 12. The application specific element encoding can be performed from a root down to the associated leaf nodes and in "a left to the right" order. During encoding at step 28, the value cross-references are preferably kept intact to help promote the correctness and integrity of the resulting compressed application 302. Encoding of the XML attribute values at step 28 also preferably matches the application specific binary dictionary 402 codes defined for attribute values in the application template 42. For example, if an attribute type is defined as:
type (label | edit | text | list | radio | checkbox | button | image)#REQUIRED then the binary dictionary 402 contains binary codes for label, edit, text, list, radio, checkbox, button, and image. When the compression tool 52 encounters type="label" in the XML application 302 definition, the tool 52 will convert this character string into the corresponding binary code assigned to "label" as represented in the dictionary 402.

Referring to Figures 3b and 4, at step 25, the software application 302 is received by the decoder 34, from the information source such as 20 (see Figure 1). Using the application definition template 42 such as the DTD or XML schema, for example, common predefined element names and attributes in the application template 42 are binary decoded at step 27. This decoding of common predefined elements is such that the binary codes for the predefined element names and attributes, in the binary compression dictionary 38, is shared between the decoder 34 and destination device 12. As such, unlike WBXML encoding, it is not required to pass the binary compression dictionary 38 with the encoded application 302 definition.

Using the hierarchical structure of the application 302 definition, step 29 involves binary decoding of the predefined application-specific data not displayed to the user of the device 12. The application specific element decoding can be performed from a root down to the associated leaf nodes and in "a left to the right" order. During decoding at step 29, the value cross-references are preferably kept intact to help promote the correctness and integrity of the resulting compressed application 302. Decoding of the XML attribute values at step 29 also preferably matches the application specific binary dictionary 402 codes defined for attribute values in the application template 42. For example, if an attribute type is defined as:
type (label | edit | text | list | radio | checkbox | buffon | image)#REQUIRED then the binary dictionary 402 contains binary codes for label, edit, text, list, radio, checkbox, button, and image. When the decoder 34 encounters type="label" in the XML application 302 definition, the decoder 34 will decode this character string from the corresponding binary code assigned to "label" as represented in the dictionary 402.

For any specific application definition template 42, the encoding/decoding could be further optimized based on the knowledge of the number of bytes (or bits) required to encode the specific application element in the definition. For example, in the DTD definition above, the binary codes for data, message, or screen elements could only require a single byte for encoding. Furthermore, the total byte range 0-xFF could be partitioned into sub byte ranges, for example, 0-x60 for data, x61-xC0 for messages and xC1-xFF for screens.

### Example 1

Consider the following generic XML document fragment as a part of an application definition:

```
          <elem1 attr11="a11.1" attr12="a12.1">
               <elem2 attr21="a21.1">data21</elem2>
               <elem2 attr21="a21.2">data22</elem2>
               <elem2 attr21="a21.3">data23</elem2>
          </elem1>
          <elem3 attr31="a31.1" attr3="[Ref]a21.1">
               <elem4 attr41="a41.1">[Ref]a11.1</elem4>
          </elem3>,
```

where [Ref] indicates the application-specific format for a cross-reference to another value in the XML document (e.g. character "@" in WirelessPizza XML example) and only attribute values *a12.1* and *a41.1* and data inside elem2 are displayable parameters to the application 302 user of the device 12.

In the compressed form this XML segment looks like:

```
          WB1 WB5 BO1 WB6 a12.1
              WB2 WB7 BO2 data21 WB2/
              WB2 WB7 BO3 data22 WB2/
              WB2 WB7 B04 data23 WB2/
          WB1/
          WB3 WB8 BO5 WB9 BO2
              WB4 WB10 a41.1 BO1 WB4/
          WB3/,
```

where WB# codes represent the result of binary encoding (step 26) and BO# codes represent the result of binary obfuscation (step 28). It should be noted that the cross-references for values *a11.1* and *a21.1* have been resolved to the same binary codes BO1 and BO2 to promote correctness and integrity of the compressed application 302. It is recognised that the WB# codes could be represented as a single code (e.g. WB1 WB5 = WB15) or as a series of multiple codes, as desired.

### Example 2

Consider the following example DTD (template 42) below to define XML resources of a wireless application 302:

```
 <!ELEMENT application (data*, msg*, screen*)>
 <!ATTLIST application
      name CDATA #REQUIRED>

 <!ELEMENT data (dfield+)>
 <!ATTLIST data
      name CDATA#REQUIRED
      persisted (true | false) "true">

 <!ELEMENT dfield (#PCDATA)>
 <!ATTLIST dfield
      name CDATA #REQUIRED
      type (String | Number | Boolean | Date Any) "Any"
      array (true | false) "false"
      nested (true | false) "false"
      nestedName CDATA #IMPLIED
      key (true false) "true">

 <!ELEMENT msg (mfield*)>
 <!ATTLIST msg
      name CDATA#REQUIRED
      mapping CDATA #IMPLIED>

 <!ELEMENT mfield (#PCDATA)>
 <!ATTLIST mfield
      name CDATA #REQUIRED
      type (String | Number | Boolean | Date | Array | XML) #IMPLIED
      mapping CDATA #IMPLIED>

 <!ELEMENT screen (control*, menu+)
 <!ATTLIST screen
      name CDATA #REQUIRED
      title CDATA #IMPLIED
      dialog (true | false) "false"
      param CDATA #IMPLIED>

 <!ELEMENT control (entry+)>
 <!ATTLIST control
      name CDATA#REQUIRED
      value CDATA #IMPLIED
      mapping CDATA#IMPLIED
      type (label | edit | text | list | | radio | checkbox | button | image)#REQUIRED
      entrytype (char | number | date | pwd | phone | email) "char"
      readOnly (true | false) "false"
      placement CDATA #IMPLIED
      style CDATA #IMPLIED>

 <!ELEMENT menu (item*)>
 <!ELEMENT item EMPTY>
 <!ATTLIST item
      name CDATA#REQUIRED
      label CDATA #REQUIRED
      screen CDATA #IMPLIED>
      msg CDATA #IMPLIED>

 <!ELEMENT entry (#PCDATA)>
```

A simple wireless application compliant with the above example template 42 (e.g. DTD) could be defined in XML as follows:

```
 <wcApp name="WirelessPizza">
      <data name="User">
            <dfield name="name" type="String" key="true"/>
            <dfield name="password" type="String"/>
           v<dfield name="street" type="String"/>
           v<dfield name="city" type="String"/>
            <dfield name="postal" type="String"/>
            <dfield name="phone" type="String"/>
      </data>
      <data name="OrderStatus">
            <dfield name="confNumber" type="Number" key="true"/>
            <dfeld name="status" type="String"/>
           <dfield name="datetime" type="Date"/>
      </data>
      <data name="Order">
            <dfield name="orderld" type="Number" key="true"/>
            <dfield name="items" type="String" array="true"/>
            <dfield name="user" nested="true" nestedName="@User"/>
            <dfield name="datetime" type="Date"/>
            <dfield name="orderStatus" nested="true"
 nestedName="@OrderStatus"/>
      </data>
      <msg name="onOrderStatusUpdate">
           <mfield name="orderld" mapping="@Order.orderld"/>
           <mfield name="status" mapping="@Order.orderStatus"/>
     </msg>
     <msg name="updateUserlnfo" mapping="User"/>
     <msg name="placeOrder" mapping="Order"/>
     <screen name="scrDelivery" title="Please provide delivery info"
 param="@User">
           <control name="IbIStreet" type= "label" value="Street:"/>
           < control name="edStreet" type="edit" mapping="@User.street"/>
           <control name="IblCity" type= "label" value="City:"/>
           <control name="edCity" type="edit" mapping="@User.city"/>
           <control name=" |b|PostalCode" type= "label" value="Postal code:"/>
           <control name=" edPostalCode" type="edit"
 mapping"@User.postal"/>
         <control name=" IblPhone" type= "label" value="Telephone:"/>
         <control name=" edPhone " type="edit" entrytype="phone"
                                           mapping"@User.phone"/>
         <menu>
              <item name="sendOrder" label="Send Order"
                    screen="@scrOrderSent" msg="@placeOrder"/>
         </menu>
  </screen>
  ...
```

It should be noted that the six specific display parameters of the application 302 are given in bold above.

The XML element tags and attribute names are encoded as binary codes, both the predefined common and application specific elements. As described above, compression according to systems and methods disclosed herein may use the fact that only displayable data intended to be displayed to the application 302 user needs to be maintained without binary conversion. The above "scrDelivery" document fragment encoded accordingly may have the following form in one exemplary implementation:

```
   [BB]Please provide delivery info[BB]
                      [BB]Street:[BB]
                      [BB]
                      [BB]City:[BB]
                      [BB]
                      [BB]Postal Code:[BB]
                      [BB]
                      [BB]Telephone:[BB]
                      [BB]
                      [BB]
                           [BB]Send Order[BB]
                           [BB]
                      [BB]
   [BB]
```

where [BB] indicates binary encoded data. It is recognised that the [BB] compressed code could also be represented as one or more binary codes for various predefined elements and attributes.

It will be appreciated that the above description relates to one or more exemplary systems and/or methods. Many variations will be obvious to those knowledgeable in the field, and such obvious variations are within the scope of this application, whether or not expressly described.

For example, although a single device 12, data server 18 and information source 20 are shown in the drawings, the data server 18 typically provides services for a plurality of devices 12, possibly via different communication networks 16, and access to a plurality of information sources 20 through different direct or network-based connections. Similarly, any communication network 16 and any information source 20 may communicate with multiple data servers 18.

The above description also assumes transfer of information from the source 20 to the device 12. However, providing the compression tool 52 at the device 12 and a compressed application system at the destination supports software application 302 and messages 105 compression in an outgoing direction from the device 12.

In some respects, compression level for outgoing content can be dependent on deployment topology and security requirements. For the Fig. 6 topology above, where the compressed application system tool 52 is implemented at an intermediate system that is remote from the application source 20 or other destination, then the entire message 105 including field names could be binary encoded. When messages 105 are exchanged with the intermediate system, the field names could be defined as binary codes. The codes are then substituted by the intermediate system with the original field names and then propagated to the destination. This model can offer the additional benefit of minimizing message 105 size. In the Fig. 7 topology above, message 105 field names might not be encodable, although other attributes of message 105 definitions, such as format, size, type, etc., are encodable.

In addition, WBXML is shown in Figs. 4 and 5 as an example encoding scheme for common XML tags and attributes. Other encoding schemes will be apparent to those skilled in the art.

## Claims

1. A method of compressing a wireless software application (302) expressed in a structured definition language, the application having a plurality of elements predefined according to an application definition template (42) and a plurality of display elements configured for presentation on a user interface (202) of a recipient wireless device (12), the method comprising the steps of:
selecting a compression format according to a compression dictionary (56) containing a plurality of codes for representing the predefined elements of the application (302) as encoded elements;
encoding common elements of the predefined elements using the selected compression format, the common elements representing the common structure for a class of software applications;
**characterized by** the steps of:
making a distinction between the display elements and non-display elements of the application (302);
encoding application specific elements of the predefined elements using the selected compression format, the encoded application specific elements comprising only non display elements, the display elements being retained in uncompressed form; and
combining the uncompressed display elements, the encoded common elements and the encoded application specific elements for generating a compressed version of the application;
wherein the compression dictionary is configured for use by the recipient wireless device (12) of the compressed application using knowledge of the application definition template (42) contents.

2. The method according to claim 1, wherein knowledge of the contents of the compression dictionary is shared by an application provider (13) providing the compressed application and the device (12).

3. The method according to claim 2, wherein the plurality of codes are binary codes for representing the predefined elements.

4. The method according to claim 2 or claim 3 further comprising the step of transmitting the compressed application from the application provider (13) to the recipient device (12) over a network (14, 16).

5. The method according to claim 4 further comprising the step of encoding the predefined elements of a communication message (105) according to the selected compression format for transmission over the network (14, 16) between the device (12) and a schema based service, the schema based service configured for interaction with the application (302) when executed on the device (12).

6. The method according to any one of claims 3 to 5 further comprising the step of using one of the binary codes to encode at least two of the predefined elements.

7. The method according to any one of claims 2 to 6 further comprising the step of selecting the same code of the plurality of codes for encoding a cross referenced value of the application (302).

8. The method according to any one of claims 3 to 7 further comprising the step of partitioning the total byte range of the binary codes into at least two sub byte ranges, the sub byte ranges for representing different types of the predefined elements.

9. A method of decompressing a compressed wireless software application (302) expressed in a structured definition language, the application having a plurality of encoded elements predefined according to an application definition template (42) and a plurality of uncompressed display elements configured for presentation on a user interface (202) of a recipient wireless device (12), knowledge of the application definition template contents being shared between the device (12) and an application provider (13) of the compressed application, the method comprising the steps of:
selecting a decompression format according to a compression dictionary (38) containing a plurality of codes for representing the predefined elements of the application (302) as encoded elements;
decoding selected ones of the predefined elements using the selected compression format, the predefined elements comprising common elements representing a common structure for a class of software applications;
**characterized by** the steps of:
decoding application specific elements only when representing non-display elements of the application, the display elements of the application content being retained in uncompressed form; and
combining the decoded predefined elements and the display elements in an uncompressed version of the application (302) configurable for subsequent execution on a runtime environment (206) of the device (12).

10. The method according to claim 9, wherein knowledge of the contents of the compression dictionary is shared by the application provider (13) providing the compressed application and the device (12).

11. The method according to any one of claims 2 to 8 and 10, wherein the application (302) is expressed in a structured definition language based on XML.

12. The method according to claim 11, wherein the common elements comprise tags and attributes for the class.

13. The method according to claim 12, wherein the application specific elements comprise attributes and values particular to the application (302).

14. The method according to claim 10, wherein the plurality of codes are binary codes for representing the predefined elements.

15. The method according to claim 10 or claim 14 further comprising the step of receiving the compressed application (302) from the application provider (13) by the recipient device (12) over a wireless network (14).

16. The method according to claim 15 further comprising the step of decoding the predefined elements of a communication message (105) according to the selected compression format for transmission over the network (14) between the device (12) and a schema based service, the schema based service configured for interaction with the application (302) when executed on the device.

17. The method according to any one of claims 14 to 16 further comprising the step of using one of the binary codes to decode at least two of the predefined elements.

18. The method according to any one of claims 10 and 14 to 16 further comprising the step of selecting the same code of the plurality of codes for decoding a cross referenced value of the application (302).

19. The method according to any one of claims 14 to 19 further comprising the step of retaining selected ones of the predefined elements in the compression format for subsequent provisioning of the uncompressed application by the runtime environment (206).

20. The method according to any one of claims 2 to 8 and 10 to 19, wherein the template comprises definitions selected from the group comprising presentation, message, and data.

21. The method according to any one of claims 2 to 8 and 10 to 19, wherein the template (42) is a schema.

22. The method according to any one of claims 2 to 8 and 10 to 19, wherein the template (42) is a document type definition.

23. The method according to any one of claims 2 to 8 and 10 to 22, wherein the structured definition language is XML based.

24. A system (52) for compressing a wireless software application (302) expressed in a structured definition language, the application having a plurality of elements predefined according to an application definition template and a plurality of display elements configured for presentation on a user interface (202) of a recipient wireless device (12), the system comprising:
an application definition template (42) for defining the predefined elements and comprising information on the display elements;
a compression dictionary (56) representing a compression format containing a plurality of codes for representing the predefined elements of the application (302) as encoded elements;
an encoder for encoding the predefined elements and common elements using the compression format, the common elements representing a common structure for a class of software applications;
**characterized in that** the encoder is configured to make a distinction between the display elements and non-display elements of the application (302) and that the encoder is configured to encode only non-display elements of the predefined elements and the common elements , the display elements of the application content being retainable by the encoder in uncompressed form; and
a generator (58) for combining the uncompressed display elements, the encoded common elements and the encoded application specific elements for generating a compressed version of the application (302);
wherein the compression dictionary (56) is configured for use by the recipient wireless device (12) of the compressed application using shared knowledge of the application definition template contents.

25. The system (52) according to claim 24, wherein knowledge of the contents of the compression dictionary (56) is shared by the device (12) and an application provider (13) providing the compressed application.

26. The system (52) according to claim 25, wherein the application (302) is expressed in a structured definition language based on XML.

27. The system (52) according to claim 26 further comprising a first encoder module of the encoder for encoding the common elements comprising tags and attributes for the class.

28. The system (52) according to claim 27 further comprising a second encoder module of the encoder for encoding the application specific elements comprising attributes and values particular to the application.

29. The system (52) according to any one of claims 25 to 28, wherein the plurality of codes are binary codes for representing the predefined elements.

30. The system (52) according to any one of claims 25 to 29 further comprising a first dictionary (400) of the compression dictionary for encoding the common elements and a second dictionary (402) of the compression dictionary for encoding the application specific elements.

31. The system (52) according to any one of claims 24 to 30, wherein the encoder (54) is configured for encoding the predefined elements of a communication message (105) according to the selected compression format for transmission over the network (14, 16) between the device (12) and a schema based service, the schema based service configured for interaction with the application (302) when executed on the device.

32. The system (52) according to any one of claims 29 to 31, wherein one of the binary codes is used to encode at least two of the predefined elements.

33. The system (52) according to any one of claims 25 to 32, wherein the same code of the plurality of codes is used for encoding a cross referenced value of the application (302).

34. The system (52) according to any one of claims 29 to 32, wherein the total byte range of the binary codes is partitioned into at least two sub byte ranges, the sub byte ranges for representing different types of the predefined elements.

35. The system (52) according to any one of claims 25 to 34, wherein the template (42) comprises definitions selected from the group comprising presentation, message, and data.

36. The system (52) according to any one of claims 25 to 34, wherein the template (42) is a schema.

37. The system (52) according to any one of claims 25 to 34, wherein the template (42) is a document type definition.

38. The system (52) according to any one of claims 35 to 37, wherein the structured definition language is XML based.

39. A system (34) for decompressing a compressed wireless software application (302) expressed in a structured definition language, the application having a plurality of encoded elements and a plurality of uncompressed display elements configured for presentation on a user interface (202) of a recipient wireless device (12), the system comprising:
an application definition template (42) for defining predefined elements and comprising information on the display elements, knowledge of the application definition template contents being shared between the device (12) and an application provider (13) of the compressed application;
a compression dictionary (38) representing a compression format containing a plurality of codes for representing the predefined elements of the application (302) as encoded elements;
a decoder including for decoding the predefined elements common elements and application specific elements using the selected decompression format, the common elements representing a common structure for a class of software applications;
**characterized by**:
the decoder being configured to decode only non-display elements of the predefined elements, the display elements of the application content being retained in uncompressed form; and
a generator (40) for combining the uncompressed display elements and the decoded predefined elements in an uncompressed version of the application configurable for subsequent execution on a runtime environment (206) of the device.

40. A computer program product for compressing or decompressing a wireless software application (302) expressed in a structured definition language, the application having a plurality of predefined elements and a plurality of display elements configured for presentation on a user interface (202) of a recipient wireless device (12), the computer program product comprising:
a computer readable medium (210) comprising program code means executable by a processor (208) of a computing device, apparatus or system for implementing the respective compressing or decompressing method of any one of claims 1 to 23.

## Patentansprüche

1. Verfahren zum Komprimieren einer in einer strukturierten Definitionssprache ausgedrückten drahtlosen Software-Anwendung (302), wobei die Anwendung eine Vielzahl von gemäß einer Anwendungsdefinitionsvorlage (42) vordefinierten Elementen und eine Vielzahl von für die Darstellung auf einer Benutzeroberfläche (202) einer drahtlosen Empfängervorrichtung (12) konfigurierten Anzeigeelementen aufweist, wobei das Verfahren folgende Schritte umfasst:
Auswählen eines Komprimierungsformats gemäß einem Komprimierungswörterbuch (56), das eine Vielzahl von Codes zum Darstellen der vordefinierten Elemente der Anwendung (302) als codierte Elemente enthält;
Codieren häufiger Elemente der vordefinierten Elemente unter Verwendung des ausgewählten Komprimierungsformats, wobei die häufigen Elemente die häufige Struktur für eine Klasse von Software-Anwendungen darstellen;
**gekennzeichnet durch** folgende Schritte:
Unterscheiden zwischen den Anzeigeelementen und Nichtanzeigeelementen der Anwendung (302);
Codieren anwendungsspezifischer Elemente der vordefinierten Elemente unter Verwendung des ausgewählten Komprimierungsformats, wobei die codierten anwendungsspezifischen Elemente nur Nichtanzeigeelemente umfassen, wobei die Anzeigeelemente in unkomprimierter Form gespeichert werden; und
Kombinieren der unkomprimierten Anzeigeelemente, der codierten häufigen Elemente und der codierten anwendungsspezifischen Elemente zum Generieren einer komprimierten Version der Anwendung;
wobei das Komprimierungswörterbuch zur Verwendung **durch** die drahtlose Empfängervorrichtung (12) der komprimierten Anwendung unter Verwendung des Wissens der Inhalte der Anwendungsdefinitionsvorlage (42) konfiguriert ist.

2. Verfahren nach Anspruch 1, wobei das Wissen der Inhalte des Komprimierungswörterbuchs von einem Anwendungsanbieter (13), der die komprimierte Anwendung bereitstellt, und der Vorrichtung (12) gemeinsam genutzt wird.

3. Verfahren nach Anspruch 2, wobei die Vielzahl der Codes Binärcodes zum Darstellen der vordefinierten Elemente sind.

4. Verfahren nach Anspruch 2 oder Anspruch 3, das ferner den Schritt des Übermittelns der komprimierten Anwendung von dem Anwendungsanbieter (13) an die Empfängervorrichtung (12) über ein Netzwerk (14, 16) umfasst.

5. Verfahren nach Anspruch 4, das ferner den Schritt des Codierens der vordefinierten Elemente einer Kommunikationsnachricht (105) gemäß dem ausgewählten Komprimierungsformat zur Übermittlung über das Netzwerk (14, 16) zwischen der Vorrichtung (12) und einem schemabasierten Dienst umfasst, wobei der schemabasierte Dienst bei der Ausführung in der Vorrichtung (12) zur Zusammenwirkung mit der Anwendung (302) konfiguriert ist.

6. Verfahren nach einem der Ansprüche 3 bis 5, das ferner den Schritt des Verwendens eines der Binärcodes umfasst, um mindestens zwei der vordefinierten Elemente zu codieren.

7. Verfahren nach einem der Ansprüche 2 bis 6, das ferner den Schritt des Auswählens des gleichen Codes der Vielzahl von Codes zum Codieren eines durch Querverweis verknüpften Werts der Anwendung (302) umfasst.

8. Verfahren nach einem der Ansprüche 3 bis 7, das ferner den Schritt des Untergliederns des gesamten Byte-Bereichs der Binärcodes in mindestens zwei Unter-Byte-Bereiche umfasst, wobei die Unter-Byte-Bereiche zum Darstellen verschiedener Arten der vordefinierten Elemente vorgesehen sind.

9. Verfahren zum Dekomprimieren einer in einer strukturierten Definitionssprache ausgedrückten komprimierten drahtlosen Software-Anwendung (302), wobei die Anwendung eine Vielzahl von gemäß einer Anwendungsdefinitionsvorlage (42) vordefinierten codierten Elementen und eine Vielzahl von für die Darstellung auf einer Benutzeroberfläche (202) einer drahtlosen Empfängervorrichtung (12) konfigurierten unkomprimierten Anzeigeelementen aufweist, wobei das Wissen der Anwendungsdefinitionsvorlageninhalte von der Vorrichtung (12) und einem Anwendungsanbieter (13) der komprimierten Anwendung gemeinsam genutzt wird, wobei das Verfahren folgende Schritte umfasst:
Auswählen eines Dekomprimierungsformats gemäß einem Komprimierungswörterbuch (38), das eine Vielzahl von Codes zum Darstellen der vordefinierten Elemente der Anwendung (302) als codierte Elemente enthält;
Decodieren ausgewählter der vordefinierten Elemente unter Verwendung des ausgewählten Komprimierungsformats, wobei die vordefinierten Elemente häufige Elemente umfassen, die eine häufige Struktur für eine Klasse von Software-Anwendungen darstellen;
**gekennzeichnet durch** folgende Schritte:
Decodieren anwendungsspezifischer Elemente nur beim Darstellen von Nichtanzeigeelementen der Anwendung, wobei die Anzeigeelemente des Anwendungsinhalts in unkomprimierter Form gespeichert werden; und
Kombinieren der decodierten vordefinierten Elemente und der Anzeigeelemente in einer unkomprimierten Version der Anwendung (302), die für eine spätere Ausführung in einer Laufzeitumgebung (206) der Vorrichtung (12) konfigurierbar sind.

10. Verfahren nach Anspruch 9, wobei das Wissen der Inhalte des Komprimierungswörterbuchs von dem Anwendungsanbieter (13), der die komprimierte Anwendung bereitstellt, und der Vorrichtung (12) gemeinsam genutzt wird.

11. Verfahren nach einem der Ansprüche 2 bis 8 und 10, wobei die Anwendung (302) in einer strukturierten Definitionssprache basierend auf XML ausgedrückt wird.

12. Verfahren nach Anspruch 11, wobei die häufigen Elemente Tags und Attribute für die Klasse umfassen.

13. Verfahren nach Anspruch 12, wobei die anwendungsspezifischen Elemente für die Anwendung (302) besondere Attribute und Werte umfassen.

14. Verfahren nach Anspruch 10, wobei die Vielzahl von Codes Binärcodes zum Darstellen der vordefinierten Elemente sind.

15. Verfahren nach Anspruch 10 oder Anspruch 14, das ferner den Schritt des Empfangens der komprimierten Anwendung (302) von dem Anwendungsanbieter (13) durch die Empfängervorrichtung (12) über ein drahtloses Netzwerk (14) umfasst.

16. Verfahren nach Anspruch 15, das ferner den Schritt des Decodierens der vordefinierten Elemente einer Kommunikationsnachricht (105) gemäß dem ausgewählten Komprimierungsformat zur Übermittlung über das Netzwerk (14) zwischen der Vorrichtung (12) und einem schemabasierten Dienst umfasst, wobei der schemabasierte Dienst bei der Ausführung in der Vorrichtung zur Zusammenwirkung mit der Anwendung (302) konfiguriert ist.

17. Verfahren nach einem der Ansprüche 14 bis 16, das ferner den Schritt des Verwendens eines der Binärcodes umfasst, um mindestens zwei der vordefinierten Elemente zu decodieren.

18. Verfahren nach einem der Ansprüche 10 und 14 bis 16, das ferner den Schritt des Auswählens des gleichen Codes der Vielzahl von Codes zum Decodieren eines durch Querverweis verknüpften Werts der Anwendung (302) umfasst.

19. Verfahren nach einem der Ansprüche 14 bis 19, das ferner den Schritt des Speicherns ausgewählter der vordefinierten Elemente in dem Komprimierungsformat zur späteren Bereitstellung der unkomprimierten Anwendung durch die Laufzeitumgebung (206) umfasst.

20. Verfahren nach einem der Ansprüche 2 bis 8 und 10 bis 19, wobei die Vorlage Definitionen umfasst, die aus der Darstellung, Nachricht und Daten umfassenden Gruppe ausgewählt werden.

21. Verfahren nach einem der Ansprüche 2 bis 8 und 10 bis 19, wobei die Vorlage (42) ein Schema ist.

22. Verfahren nach einem der Ansprüche 2 bis 8 und 10 bis 19, wobei die Vorlage (42) eine Dokumenttyp-Definition ist.

23. Verfahren nach einem der Ansprüche 2 bis 8 und 10 bis 22, wobei die strukturierte Definitionssprache XML-basiert ist.

24. System (52) zum Komprimieren einer in einer strukturierten Definitionssprache ausgedrückten drahtlosen Software-Anwendung (302), wobei die Anwendung eine Vielzahl von gemäß einer Anwendungsdefinitionsvorlage vordefinierten Elementen und eine Vielzahl von für die Darstellung auf einer Benutzeroberfläche (202) einer drahtlosen Empfängervorrichtung (12) konfigurierten Anzeigeelementen aufweist, wobei das System umfasst:
eine Anwendungsdefinitionsvorlage (42) zum Definieren der vordefinierten Elemente, die Informationen zu den Anzeigeelementen umfasst;
ein Komprimierungswörterbuch (56), das ein Komprimierungsformat darstellt, das eine Vielzahl von Codes zum Darstellen der vordefinierten Elemente der Anwendung (302) als codierte Elemente enthält;
einen Codierer zum Codieren der vordefinierten Elemente und häufigen Elemente unter Verwendung des Komprimierungsformats, wobei die häufigen Elemente eine häufige Struktur für eine Klasse von Software-Anwendungen darstellen;
**dadurch gekennzeichnet, dass** der Codierer zum Unterscheiden zwischen den Anzeigeelementen und Nichtanzeigeelementen der Anwendung (302) konfiguriert ist und dass der Codierer zum Codieren nur von Nichtanzeigeelementen der vordefinierten Elemente und der häufigen Elemente konfiguriert ist, wobei die Anzeigeelemente des Anwendungsinhalts durch den Codierer in unkomprimierter Form speicherbar sind; und
einen Generator (58) zum Kombinieren der unkomprimierten Anzeigeelemente, der codierten häufigen Elemente und der codierten anwendungsspezifischen Elemente zum Generieren einer komprimierten Version der Anwendung (302);
wobei das Komprimierungswörterbuch (56) zur Verwendung durch die drahtlose Empfängervorrichtung (12) der komprimierten Anwendung unter Verwendung des gemeinsam genutzten Wissens der Anwendungsdefinitionsvorlageninhalte konfiguriert ist.

25. System (52) nach Anspruch 24, wobei das Wissen der Inhalte des Komprimierungswörterbuchs (56) von der Vorrichtung (12) und einem Anwendungsanbieter (13), der die komprimierte Anwendung bereitstellt, gemeinsam genutzt wird.

26. System (52) nach Anspruch 25, wobei die Anwendung (302) in einer strukturierten Definitionssprache basierend auf XML ausgedrückt wird.

27. System (52) nach Anspruch 26, das ferner ein erstes Codierermodul des Codierers zum Codieren der häufigen Elemente umfasst, die Tags und Attribute für die Klasse umfassen.

28. System (52) nach Anspruch 27, das ferner ein zweites Codierermodul des Codierers zum Codieren der anwendungsspezifischen Elemente umfasst, die für die Anwendung besondere Attribute und Werte umfassen.

29. System (52) nach einem der Ansprüche 25 bis 28, wobei die Vielzahl von Codes Binärcodes zum Darstellen der vordefinierten Elemente sind.

30. System (52) nach einem der Ansprüche 25 bis 29, das ferner ein erstes Wörterbuch (400) des Komprimierungswörterbuchs zum Codieren der häufigen Elemente und ein zweites Wörterbuch (402) des Komprimierungswörterbuchs zum Codieren der anwendungsspezifischen Elemente umfasst.

31. System (52) nach einem der Ansprüche 24 bis 30, wobei der Codierer (54) zum Codieren der vordefinierten Elemente einer Kommunikationsnachricht (105) gemäß dem ausgewählten Komprimierungsformat zur Übermittlung über das Netzwerk (14, 16) zwischen der Vorrichtung (12) und einem schemabasierten Dienst konfiguriert ist, wobei der schemabasierte Dienst bei der Ausführung in der Vorrichtung zur Zusammenwirkung mit der Anwendung (302) konfiguriert ist.

32. System (52) nach einem der Ansprüche 29 bis 31, wobei einer der Binärcodes verwendet wird, um mindestens zwei der vordefinierten Elemente zu codieren.

33. System (52) nach einem der Ansprüche 25 bis 32, wobei der gleiche Code der Vielzahl von Codes zum Codieren eines durch Querverweis verknüpften Werts der Anwendung (302) verwendet wird.

34. System (52) nach einem der Ansprüche 29 bis 32, wobei der gesamte Byte-Bereich der Binärcodes in mindestens zwei Unter-Byte-Bereiche untergliedert ist, wobei die Unter-Byte-Bereiche zum Darstellen verschiedener Arten der vordefinierten Elemente vorgesehen sind.

35. System (52) nach einem der Ansprüche 25 bis 34, wobei die Vorlage (42) Definitionen umfasst, die aus der Darstellung, Nachricht und Daten umfassenden Gruppe ausgewählt werden.

36. System (52) nach einem der Ansprüche 25 bis 34, wobei die Vorlage (42) ein Schema ist.

37. System (52) nach einem der Ansprüche 25 bis 34, wobei die Vorlage (42) eine Dokumenttyp-Definition ist.

38. System (52) nach einem der Ansprüche 35 bis 37, wobei die strukturierte Definitionssprache XML-basiert ist.

39. System (34) zum Dekomprimieren einer in einer strukturierten Definitionssprache ausgedrückten komprimierten drahtlosen Software-Anwendung (302), wobei die Anwendung eine Vielzahl von codierten Elementen und eine Vielzahl von unkomprimierten Anzeigeelementen aufweist, die zur Darstellung auf einer Benutzeroberfläche (202) einer drahtlosen Empfängervorrichtung (12) konfiguriert sind, wobei das System umfasst:
eine Anwendungsdefinitionsvorlage (42) zum Definieren vordefinierter Elemente, die Informationen zu den Anzeigeelementen umfasst, wobei das Wissen der Anwendungsdefinitionsvorlageninhalte von der Vorrichtung (12) und einem Anwendungsanbieter (13) der komprimierten Anwendung gemeinsam genutzt wird;
ein Komprimierungswörterbuch (38), das ein Komprimierungsformat darstellt, das eine Vielzahl von Codes zum Darstellen der vordefinierten Elemente der Anwendung (302) als codierte Elemente enthält;
einen Decodierer zum Decodieren der vordefinierten Elemente einschließlich häufiger Elemente und anwendungsspezifischer Elemente unter Verwendung des ausgewählten Dekomprimierungsformats, wobei die häufigen Elemente eine häufige Struktur für eine Klasse von Software-Anwendungen darstellen;
**gekennzeichnet durch**:
den Decodierer, der zum Decodieren nur von Nichtanzeigeelementen der vordefinierten Elemente konfiguriert ist, wobei die Anzeigeelemente des Anwendungsinhalts in unkomprimierter Form gespeichert werden; und
einen Generator (40) zum Kombinieren der unkomprimierten Anzeigeelemente und der decodierten vordefinierten Elemente in einer unkomprimierten Version der Anwendung, die für eine spätere Ausführung in einer Laufzeitumgebung (206) der Vorrichtung konfigurierbar sind.

40. Computerprogrammprodukt zum Komprimieren oder Dekomprimieren einer in einer strukturierten Definitionssprache ausgedrückten drahtlosen Software-Anwendung (302), wobei die Anwendung eine Vielzahl von vordefinierten Elemente und eine Vielzahl von Anzeigeelementen aufweist, die zur Darstellung auf einer Benutzeroberfläche (202) einer drahtlosen Empfängervorrichtung (12) konfiguriert sind, wobei das Computerprogrammprodukt umfasst:
ein computerlesbares Medium (210), das von einem Prozessor (208) einer Computervorrichtung, eines Computergeräts oder eines Computersystems ausführbare Programmcodemittel zum Durchführen des jeweiligen Komprimierungs- oder Dekomprimierungsverfahrens nach einem der Ansprüche 1 bis 23 umfasst.

## Revendications

1. Un procédé destiné à compresser une application logicielle sans fil (302) exprimée dans un langage de définition structuré, l'application possédant une pluralité d'éléments prédéfinis selon un modèle de définition d'application (42) et une pluralité d'éléments d'affichage configurés pour une présentation sur une interface utilisateur (202) d'un dispositif sans fil de réception (12), le procédé comprenant les opérations suivantes :
la sélection d'un format de compression selon un dictionnaire de compression (56) contenant une pluralité de codes destinés à représenter les éléments prédéfinis de l'application (302) sous la forme d'éléments codés,
le codage des éléments communs des éléments prédéfinis au moyen du format de compression sélectionné, les éléments communs représentant la structure commune d'une classe d'applications logicielles,
**caractérisé par** les opérations suivantes :
la distinction entre les éléments d'affichage et les éléments sans affichage de l'application (302),
le codage des éléments spécifiques à l'application des éléments prédéfinis au moyen du format de compression sélectionné, les éléments spécifiques à l'application codés comprenant uniquement des éléments sans affichage, les éléments d'affichage étant conservés dans un format non compressé, et
la combinaison des éléments d'affichage non compressés, des éléments communs codés et des éléments spécifiques à l'application codés afin de générer une version compressée de l'application,
où le dictionnaire de compression est configuré pour une utilisation par le dispositif sans fil de réception (12) de l'application compressée en utilisant des connaissances relatives aux contenus du modèle de définition d'application (42).

2. Le procédé selon la Revendication 1, où les connaissances des contenus du dictionnaire de compression sont partagées par un fournisseur d'applications (13) fournissant l'application compressée et le dispositif (12).

3. Le procédé selon la Revendication 2, où la pluralité de codes sont des codes binaires destinés à représenter les éléments prédéfinis.

4. Le procédé selon la Revendication 2 ou 3 comprenant en outre l'opération de transmission de l'application compressée du fournisseur d'applications (13) au dispositif de réception (12) par l'intermédiaire d'un réseau (14, 16).

5. Le procédé selon la Revendication 4 comprenant en outre l'opération de codage des éléments prédéfinis d'un message de communication (105) selon le format de compression sélectionné pour une transmission par l'intermédiaire du réseau (14, 16) entre le dispositif (12) et un service basé sur des schémas, le service basé sur des schémas étant configuré pour une interaction avec l'application (302) lorsqu'elle est exécutée sur le dispositif (12).

6. Le procédé selon l'une quelconque des Revendications 3 à 5 comprenant en outre l'opération d'utilisation de l'un des codes binaires afin de coder au moins deux des éléments prédéfinis.

7. Le procédé selon l'une quelconque des Revendications 2 à 6 comprenant en outre l'opération de sélection du même code de la pluralité de codes afin de coder une valeur à référence croisée de l'application (302).

8. Le procédé selon l'une quelconque des Revendications 3 à 7 comprenant en outre l'opération de partitionnement de la gamme d'octets totale des codes binaires en au moins deux sous-gammes d'octets, les sous-gammes d'octets étant destinées à représenter différents types des éléments prédéfinis.

9. Un procédé destiné à décompresser une application logicielle sans fil compressée (302) exprimée dans un langage de définition structuré, l'application possédant une pluralité d'éléments codés prédéfinis selon un modèle de définition d'application (42) et une pluralité d'éléments d'affichage non compressés configurés pour une présentation sur une interface utilisateur (202) d'un dispositif sans fil de réception (12), des connaissances relatives aux contenus du modèle de définition d'application étant partagées entre le dispositif (12) et un fournisseur d'applications (13) de l'application compressée, le procédé comprenant les opérations suivantes :
la sélection d'un format de décompression selon un dictionnaire de compression (38) contenant une pluralité de codes destinés à représenter les éléments prédéfinis de l'application (302) sous la forme d'éléments codés,
le décodage d'éléments sélectionnés parmi les éléments prédéfinis au moyen du format de compression sélectionné, les éléments prédéfinis comprenant des éléments communs représentant une structure commune d'une classe d'applications logicielles,
**caractérisé par** les opérations suivantes :
le décodage d'éléments spécifiques à l'application uniquement lorsqu'ils représentent des éléments sans affichage de l'application, les éléments d'affichage du contenu de l'application étant conservés dans une forme non compressée, et
la combinaison des éléments prédéfinis décodés et des éléments d'affichage dans une version non compressée de l'application (302) configurable pour une exécution subséquente dans un environnement d'exécution (206) du dispositif (12).

10. Le procédé selon la Revendication 9, où les connaissances des contenus du dictionnaire de compression sont partagées par le fournisseur d'applications (13) fournissant l'application compressée et le dispositif (12).

11. Le procédé selon l'une quelconque des Revendications 2 à 8 et 10, où l'application (302) est exprimée dans un langage de définition structuré basé sur XML.

12. Le procédé selon la Revendication 11, où les éléments communs comprennent des étiquettes et des attributs pour la classe.

13. Le procédé selon la Revendication 12, où les éléments spécifiques à l'application comprennent des attributs et des valeurs propres à l'application (302).

14. Le procédé selon la Revendication 10, où la pluralité de codes sont des codes binaires destinés à représenter les éléments prédéfinis.

15. Le procédé selon la Revendication 10 ou 14 comprenant en outre l'opération de réception de l'application compressée (302) du fournisseur d'applications (13) par le dispositif de réception (12) par l'intermédiaire d'un réseau sans fil (14).

16. Le procédé selon la Revendication 15 comprenant en outre l'opération de décodage des éléments prédéfinis d'un message de communication (105) selon le format de compression sélectionné pour une transmission par l'intermédiaire du réseau (14) entre le dispositif (12) et un service basé sur des schémas, le service basé sur des schémas étant configuré pour une interaction avec l'application (302) lorsqu'elle est exécutée sur le dispositif.

17. Le procédé selon l'une quelconque des Revendications 14 à 16 comprenant en outre l'opération d'utilisation de l'un des codes binaires afin de décoder au moins deux des éléments prédéfinis.

18. Le procédé selon l'une quelconque des Revendications 10 et 14 à 16 comprenant en outre l'opération de sélection du même code de la pluralité de codes afin de décoder une valeur à référence croisée de l'application (302).

19. Le procédé selon l'une quelconque des Revendications 14 à 19 comprenant en outre l'opération de conservation des éléments sélectionnés parmi les éléments prédéfinis dans le format de compression pour une mise en service subséquente de l'application non compressée par l'environnement d'exécution (206).

20. Le procédé selon l'une quelconque des Revendications 2 à 8 et 10 à 19, où le modèle comprend des définitions sélectionnées dans le groupe comprenant présentation, message et données.

21. Le procédé selon l'une quelconque des Revendications 2 à 8 et 10 à 19, où le modèle (42) est un schéma.

22. Le procédé selon l'une quelconque des Revendications 2 à 8 et 10 à 19, où le modèle (42) est une définition de type de document.

23. Le procédé selon l'une quelconque des Revendications 2 à 8 et 10 à 22, où le langage de définition structuré est basé sur XML.

24. Un système (52) destiné à compresser une application logicielle sans fil (302) exprimée dans un langage de définition structuré, l'application possédant une pluralité d'éléments prédéfinis selon un modèle de définition d'application et une pluralité d'éléments d'affichage configurés pour une présentation sur une interface utilisateur (202) d'un dispositif sans fil de réception (12), le système comprenant :
un modèle de définition d'application (42) destiné à définir les éléments prédéfinis et comprenant des informations relatives aux éléments d'affichage,
un dictionnaire de compression (56) représentant un format de compression contenant une pluralité de codes destinés à représenter les éléments prédéfinis de l'application (302) sous la forme d'éléments codés,
un codeur destiné à coder les éléments prédéfinis et les éléments communs au moyen du format de compression, les éléments communs représentant une structure commune d'une classe d'applications logicielles,
**caractérisé en ce que** le codeur est configuré de façon à faire une distinction entre les éléments d'affichage et les éléments sans affichage de l'application (302) et **en ce que** le codeur est configuré de façon à coder uniquement les éléments sans affichage des éléments prédéfinis et des éléments communs, les éléments d'affichage du contenu de l'application pouvant être conservés par le codeur dans un format non compressé, et
un générateur (58) destiné à combiner les éléments d'affichage non compressés, les éléments communs codés et les éléments codés spécifiques à l'application afin de générer une version compressée de l'application (302),
où le dictionnaire de compression (56) est configuré pour une utilisation par le dispositif sans fil de réception (12) de l'application compressée en utilisant les connaissances partagées relatives aux contenus du modèle de définition d'application.

25. Le système (52) selon la Revendication 24, où les connaissances des contenus du dictionnaire de compression (56) sont partagées par le dispositif (12) et un fournisseur d'applications (13) fournissant l'application compressée.

26. Le système (52) selon la Revendication 25, où l'application (302) est exprimée dans un langage de définition structuré basé sur XML.

27. Le système (52) selon la Revendication 26 comprenant en outre un premier module de codage du codeur destiné à coder les éléments communs comprenant des étiquettes et des attributs pour la classe.

28. Le système (52) selon la Revendication 27 comprenant en outre un deuxième module de codage du codeur destiné à coder les éléments spécifiques à l'application comprenant des attributs et des valeurs propres à l'application.

29. Le système (52) selon l'une quelconque des Revendications 25 à 28, où la pluralité de codes sont des codes binaires destinés à représenter les éléments prédéfinis.

30. Le système (52) selon l'une quelconque des Revendications 25 à 29 comprenant en outre un premier dictionnaire (400) du dictionnaire de compression destiné à coder les éléments communs et un deuxième dictionnaire (402) du dictionnaire de compression destiné à coder les éléments spécifiques à l'application.

31. Le système (52) selon l'une quelconque des Revendications 24 à 30, où le codeur (54) est configuré pour le codage des éléments prédéfinis d'un message de communication (105) selon le format de compression sélectionné pour une transmission par l'intermédiaire du réseau (14, 16) entre le dispositif (12) et un service basé sur des schémas, le service basé sur des schémas étant configuré pour une interaction avec l'application (302) lorsqu'elle est exécutée sur le dispositif.

32. Le système (52) selon l'une quelconque des Revendications 29 à 31, où l'un des codes binaires est utilisé pour coder au moins deux des éléments prédéfinis.

33. Le système (52) selon l'une quelconque des Revendications 25 à 32, où le même code de la pluralité de codes est utilisé pour coder une valeur à référence croisée de l'application (302).

34. Le système (52) selon l'une quelconque des Revendications 29 à 32, où la gamme d'octets totale des codes binaires est partitionnée en au moins deux sous-gammes d'octets, les sous-gammes d'octets étant destinées à représenter différents types des éléments prédéfinis.

35. Le système (52) selon l'une quelconque des Revendications 25 à 34, où le modèle (42) comprend des définitions sélectionnées dans le groupe comprenant présentation, message et données.

36. Le système (52) selon l'une quelconque des Revendications 25 à 34, où le modèle (42) est un schéma.

37. Le système (52) selon l'une quelconque des Revendications 25 à 34, où le modèle (42) est une définition de type de document.

38. Le système (52) selon l'une quelconque des Revendications 35 à 37, où le langage de définition structuré est basé sur XML.

39. Un système (34) destiné à décompresser une application logicielle sans fil compressée (302) exprimée dans un langage de définition structuré, l'application possédant une pluralité d'éléments codés prédéfinis et une pluralité d'éléments d'affichage non compressés configurés pour une présentation sur une interface utilisateur (202) d'un dispositif sans fil de réception (12), le système comprenant :
un modèle de définition d'application (42) destiné à définir des éléments prédéfinis et comprenant des informations relatives aux éléments d'affichage, des connaissances relatives aux contenus du modèle de définition d'application étant partagées entre le dispositif (12) et un fournisseur d'applications (13) de l'application compressée,
un dictionnaire de compression (38) représentant un format de compression contenant une pluralité de codes destinés à représenter les éléments prédéfinis de l'application (302) sous la forme d'éléments codés,
un décodeur destiné à décoder les éléments prédéfinis, y compris des éléments communs et des éléments spécifiques à l'application au moyen du format de compression sélectionné, les éléments communs représentant une structure commune d'une classe d'applications logicielles,
**caractérisé en ce que**
le décodeur est configuré de façon à décoder uniquement les éléments sans affichage parmi les éléments prédéfinis, les éléments d'affichage du contenu de l'application étant conservés dans une forme non compressée, et
un générateur (40) destiné à combiner les éléments d'affichage non compressés et les éléments prédéfinis décodés en une version non compressée de l'application configurable pour une exécution subséquente dans un environnement d'exécution (206) du dispositif.

40. Un programme informatique destiné à compresser ou décompresser une application logicielle sans fil (302) exprimée dans un langage de définition structuré, l'application possédant une pluralité d'éléments prédéfinis et une pluralité d'éléments d'affichage configurés pour une présentation sur une interface utilisateur (202) d'un dispositif sans fil de réception (12), le programme informatique comprenant :
un support lisible par ordinateur (210) comprenant du code de programme exécutable par un processeur (208) d'un dispositif, appareil ou système informatique destiné à mettre en oeuvre le procédé de compression et de décompression respectif selon l'une quelconque des Revendications 1 à 23.
